(19) Europäisches Patentamt
European Patent Office
Office européen des brevets

(11) **EP 4 657 780 A1**

(12) **EUROPEAN PATENT APPLICATION**

(43) Date of publication:
**03.12.2025 Bulletin 2025/49**

(21) Application number: **24305830.2**

(22) Date of filing: **27.05.2024**

(51) International Patent Classification (IPC):
*H04L 1/00* (2006.01)     *H04L 5/00* (2006.01)
*H04L 5/02* (2006.01)     *H04L 27/02* (2006.01)
*H03M 7/30* (2006.01)     *H03M 13/31* (2006.01)
*H03M 13/35* (2006.01)

(52) Cooperative Patent Classification (CPC):
**H04L 1/0015; H03M 13/31; H03M 13/353;
H04L 5/0058; H04L 5/02;** H03M 7/6041

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Commissariat à l'Energie Atomique et aux
Energies
Alternatives
75015 Paris (FR)**
• **UNIVERSITE DE BORDEAUX
33000 Bordeaux (FR)**

• **Institut Polytechnique de Bordeaux
33402 Talence Cedex (FR)**
• **Centre National de la Recherche Scientifique
75016 Paris (FR)**

(72) Inventors:
• **CALVANESE STRINATI, Emilio
38054 GRENOBLE CEDEX 9 (FR)**
• **RIVET, François
33400 TALENCE (FR)**

(74) Representative: **Lavoix
2, place d'Estienne d'Orves
75441 Paris Cedex 09 (FR)**

(54) **METHOD FOR CARRYING OUT A SEMANTIC COMMUNICATION AND ASSOCIATED SEMANTIC COMMUNICATION SYSTEM**

(57) The present invention concerns a method for carrying out a semantic communication within a semantic communication system (10) defining a semantic communication channel, the semantic communication system (10) comprising a sender (12) and a receiver (14) connected through a wireless channel (16), the method comprising the following phases:

- semantic communication setting comprising determining multiple semantic functions to be embedded into a waveform;
- semantic adaption of the waveform to embed the multiple semantic functions;
- semantic transmission of the adapted waveform in a form of an electromagnetic signal.

FIG.1

EP 4 657 780 A1

**Description**

FIELD OF THE INVENTION

The present invention concerns a method for carrying out a semantic communication and a semantic communication system associated to such a method.

The invention can have numerous industrial applications which are related to any service that implies the share of knowledge between intelligent agents (natural or artificial intelligence (AI)) using for example a large amount of data. In some cases, the amount of data can be relatively small but using the semantic communication, the receiver can learn how to communicate and how to operate thanks to the exchanged information. The extreme case can comprise sending just few control bits.

An example where a semantic communication can be applied is the cooperative-robots. Another example is a virtual world type applications, where a digital copy is created in a digital twin. With this type of applications, the virtual service provider responsible for creating and rendering the digital twin, is required to use the data collected by (IoT) devices to create the virtual copy of the physical world that implies transmission of a big amount of data.

To solve these challenges, data can be exchanged in form of processable knowledge, thus applying semantic communication principles to minimize the size of the transmitted data over the wireless channels and maximize the effectiveness of the shared information.

BACKGROUND OF THE INVENTION

According to the Shannon-Weaver model, communication of digital or analogue data can be categorized in three levels: (i) transmission of symbols (the technical problem); (ii) semantic exchange of transmitted symbols (the semantic problem); (iii) effect of semantic information exchange (the effectiveness problem). In the past 70 years, based on the Shannon-Weaver model, communications primarily focused on how to accurately and effectively transmit symbols from the transmitter to the receiver. Today, after having developed the fifth generations (5G) of wireless communication systems and kick-offing research on beyond 5G, groundbreaking solutions are needed to distil data and rethink intelligence transmission exchanges for enabling reliable cognition and task execution at the receiver rather than furthermore gradually approaching to communication limits defined by the Shannon-Weaver model. The assumption that semantics are not relevant in no longer true and should be taken into consideration in the further developments of the communication techniques.

Recently with the growing interdependence between communication systems and AI, new attempts to algorithmically address the semantic communication (also called "SemCom") opportunity have emerged, leveraging on advances in the field of, for example, representation learning, transformer architectures with attention mechanisms. End-to-end (E2E) neural architecture is devised to enable semantic transmission of Natural Language Processing (NLP) based sentences, speech signals transmission, object recognitions (in images and videos). Transformers applicability is today understood to be effective mainly in such fields of applications.

The prior-art works relative to the semantic communication are not however fully satisfactory. Particularly, the semantic communication methods according to the art are not conceived to transfer all data necessary to semantic communication in an optimal way.

SUMMARY OF THE INVENTION

The present invention aims to remedy these disadvantages of the art and to propose a semantic communication method allowing transmission of all data necessary to the semantic communication in an optimal way.

For this purpose, the invention concerns a method for carrying out a semantic communication within a semantic communication system defining a semantic communication channel, the semantic communication system comprising a sender and a receiver connected through a wireless channel, the method comprising the following phases:

- semantic communication setting comprising determining multiple semantic functions to be embedded into a waveform;
- semantic adaption of the waveform to embed the multiple semantic functions;
- semantic transmission of the adapted waveform in a form of an electromagnetic signal.

Provided with these features, the present invention addresses the challenge of jointly adapting the semantic chain (semantic extraction from data this selecting semantic concepts given a semantic extraction rule/function, mapping of semantic concepts into semantic symbols that also includes the number of semantic symbols adopted to represent concepts) with the adaptation of a waveform that is sent through a wireless channel.

In addition, the present invention offers a method for embedding simultaneously multiple functions into the same semantic waveform instance in an adaptive way. A semantic waveform is a waveform that carries semantic messages in addition to its usual signal content over a physical layer/wireless modulated/ waveform carrying symbols/bits over the medium. The semantic waveform is modulated in a way that embeds additional semantic information, such as metadata, semantic concepts, and their relations, etc., into the signal itself.

According to different embodiments disclosed in more detail below, the semantic waveform may be adapted based on: (1) a physical communication channel quality (estimated or predicted), (2) a semantic communication channel quality (estimated or predicted), and, (3) the specific wireless signal and Radio Frequency hardware architecture which operates the conversion from (semantic) symbols to be transmitted to the receiver (semantic communication symbols) to the baseband modulated physical signal (modulation and coding scheme), (4) the target required function resolution (or any specific quality indicator specific for the function of each embedded function.

According to some embodiments, each semantic function comprises a functionality chosen in the list comprising:

- communication;
- sensing;
- localization;
- semantic symbols transmission;
- machine learning training;
- synchronization;
- context estimation.

According to some embodiments, the phase of semantic communication setting comprises the following steps:

- determining of a target number Nf of the multiple semantic functions to be embedded into the waveform;
- checking whether the Nf functions can be embedded simultaneously into the same waveform;
- estimating a quality of the semantic communication channel;
- estimating a quality of the wireless channel;
- determining semantic messages from data to be transmitted comprising the following sub-steps:

    - identifying a set of semantic concepts to be communicated;
    - selecting from the set sematic concepts depending on a targeted semantic compression to form semantic communications operation points between the sender and the receiver, the targeted semantic compression being defined based on the estimated qualities of the semantic communication channel and the wireless channel;

- extracting semantic concepts and relations between semantic concepts to be transmitted.

According to some embodiments, if during the checking step the Nf functions cannot be embedded simultaneously into the same waveform, said step further comprising determining a maximal number of functions that can be embedded into the waveform;
the other steps of the method being implemented for this maximal number of functions.

According to some embodiments, the phase of semantic communication settings further comprises a step of estimating a quality of a virtual semantic-wireless channel link, the targeted semantic compression being defined based on said virtual semantic-wireless channel link quality.

According to some embodiments, the phase of semantic adaption of the waveform comprises the following steps carried out for each semantic function:

- selecting of a set of semantic waveform operation points to adapt the waveform based on a waveform adaption strategy;
- estimation of waveform degradation impact on semantic interpretation at the receiver for the set of semantic waveform operation points;
- ranking of the semantic waveform operation points;
- selection of ranked semantic waveform operation points based on a predetermined threshold;
- for the selected waveform operation points, determining clusters of waveform coefficients of an associated function presenting the waveform and associating semantic symbols to each cluster representing a semantic concept;
- checking for a loop halt.

According to some embodiments, the waveform adaption strategy comprises at least one of the elements chosen in the group comprising:

- adaptation only considering the estimated quality of the semantic communication channel;
- adaptation only considering the estimated quality of the wireless channel;
- adaptation considering an estimated quality of a virtual semantic-wireless channel link;
- adaptation to improve wireless channel or semantic communication channel or virtual semantic-communication channel robustness;
- adaptation to reduce wireless channel or semantic communication channel or virtual semantic-communication channel robustness.

According to some embodiments, the phase of semantic adaption of the waveform further comprises a step of determining relevant hardware constraints, the waveform adaption strategy further comprising adaption based on the relevant hardware constraints.

According to some embodiments, the adaptation of the waveform includes adaptation of one the elements chosen in the group comprising:

- number of semantic symbols included into the waveform;
- number of waveform coefficients combined in the same waveform;
- amplitude of waveform coefficients;

- specific placement of waveform coefficients in the waveform;
- number of waveform coefficients per each semantic symbol.

According to some embodiments, the ranking of the semantic waveform operation points is based on at least one of the elements chosen in the group comprising:

- minimal coefficient use/occupation of the corresponding function Fi;
- minimal associated transmission function at the sender;
- maximal semantic communication compression;
- maximal function reliability against wireless channel noise and interference;
- maximal function reliability against semantic communication channel noise;
- maximal function reliability against truncated computation at semantic interpretation.

According to some embodiments, during the step of checking for a loop halt, the loop is stopped when all functions have been processed or when no residual waveform coefficient remains.

According to some embodiments, the phase of semantic transmission comprises the following steps:

- generation of a multifunction waveform;
- wireless transmission of the multifunction waveform.

According to some embodiments, the method further comprises a phase of semantic receiving comprising the following steps:

- reception of an electromagnetic signal comprising reception of each waveform coefficient, its conversion into amplitude, number and placement in accordance with spectral rules, the coefficient being then translated into semantic symbols;
- checking of the correct reception and creating a feedback to the sender.

The present invention also concerns a semantic communication system comprising:

- a sender able to generate and send semantic symbols;
- a receiver able to receive the semantic symbols and process them to extract corresponding data;
- a wireless channel configured to transmit the semantic symbols in form of radio signals, from the sender to the receiver;

the sender, the receiver and the wireless channel being adapted to carry out the method as defined above.

BRIEF DESCRIPTION OF THE DRAWINGS

The invention and its advantages will be better understood upon reading the following description, which is given solely by way of non-limiting example and which is made with reference to the appended drawings, in which:

- Figure 1 is a schematic view of a semantic communication system according to the invention;

- Figure 2 is a semantic chain used to generate semantic symbols in a sender of the semantic communication system of Figure 1;

- Figure 3 is a diagram of a method for carrying out a semantic communication by the semantic communication system of Figure 1; and

- Figure 4 is a diagram illustrating one of the steps of the method of Figure 3.

DETAILED DESCRIPTION OF THE INVENTION

Before describing the invention, it is to be understood that it is not limited to the details of construction set forth in the following description. It will be apparent to those skilled in the art having the benefit of the present disclosure that the invention is capable of other embodiments and of being practiced or being carried out in various ways.

As used herein, the term **"semantic communication"** or **"SemCom"** refers to a type of communication of digital data involving transmission semantic symbols between a sender and a receiver. Particularly, according to one definition given in the art, a semantic communication is a communication framework which is involved in the Level B of the 3-levels communication problems introduced by WEAVER, W. The Mathematical Theory of Communication. 1949, ch. Recent Contributions to the Mathematical Theory of Communication. This Level B relates to the semantic problem of accurately reproducing the desired meanings of symbols. Thus, in a semantic communication system meanings of transmitted messages over a noisy channel are explicitly taken into account at the receiver and where the target is not the error-free bit-fidelity decoding of the received messages but rather their correct interpretation by the receiver.

As used herein, the term **"semantic communication channel"** refers to means adapted to carry out the semantic communication.

As used herein, the term **"function"** or **"semantic function"** refers to any functionality used to carry out the operation of a semantic communication system at the semantic level, such as:

- communication;

- sensing;
- localization;
- semantic symbols transmission;
- machine learning training;
- synchronization;
- context estimation (channel ; operation environment for ex. for cobots, etc.)

Some of functions having similar functionalities can be regrouped to a same family. These families can for example be: adaption functions, control functions, signaling functions, estimation/predictions functions, synchronization functions, etc.

As used herein, the term **"semantic communications operation points"** and denoted sometimes as $Sem_{OP}^{Txi,Rxj}$ refers to the operation point that defines selected operation points for the trade-off semantic compression versus the nominal semantic robustness. This selection may be based on the estimate (or prediction) of the joint virtual wireless-semantic channel.

As used herein, the term **"semantic waveform operation points"** and denoted sometimes as $SWF_{OP}$ refers to the set of possible semantic communications operation points $Sem_{OP}^{Txi,RXj}$ given the constraints relative to the semantic channel and/or wireless channel. These constraints are further detailed in the description of step 109 below.

As used herein, the term **"RF mask"** refers to parameters used to carry out a wireless channel within predetermined limits (frequency, amplitude, etc.) by a current local regulation. This mask ensures that RF signals transmitted by devices stay within designated frequency bands and do not interfere with other communication systems.

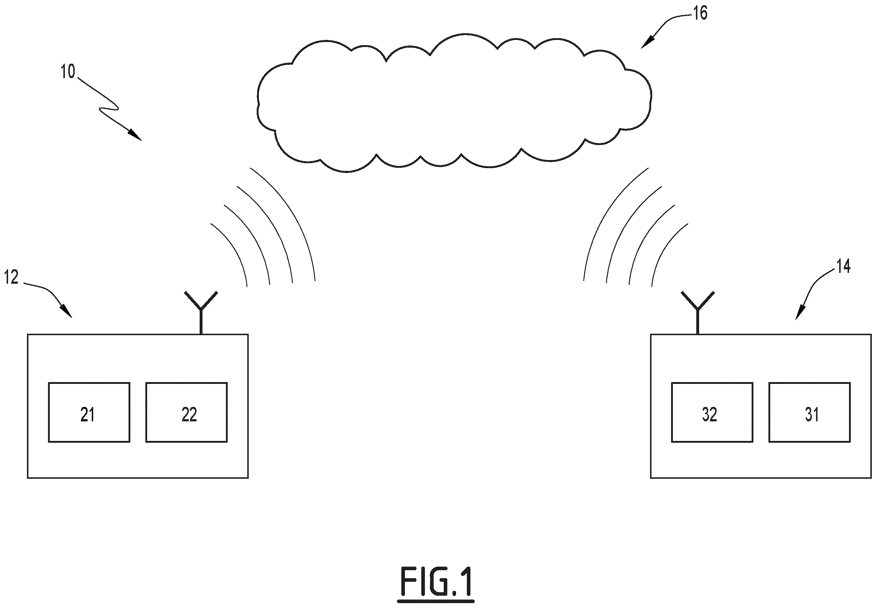

Figure 1 shows a semantic communication system 10 according to the invention. This communication system 10 comprises at least a sender 12, a receiver 14 and a wireless channel 16 connecting the sender 12 and the receiver 14. In the example of Figure 1, only one sender 12, one receiver 14 and one wireless channel 16 are shown. However, those skilled in art would understand that in a general case, any number of senders and receivers as well as wireless channels connecting these senders and these receivers, is possible. Additionally, the or each sender 12 can also be a receiver and the or each receiver 14 can also be a sender, depending on the communication direction carried out between these entities. In the further description, the case of only one sender 12 and only one receiver 14 will be explained in further detail.

The sender 12 is able to generate and send semantic symbols to the receiver 14 via the wireless channel 16. Particularly, the sender 12 can also be referred as a "teacher" since it shares processed version of observed data to assist the receiver 14 (or "learner") to operate an inference task or to extract selected information. The sender 12 comprises a semantic chain 21 able to generate semantic symbols from observed data and a physical layer 22 able to transform these semantic symbols into radiofrequency signals to be transmitted via the wireless channel 16. For this purpose, the physical layer 22 can comprise an encoder, a modulator, a waveform adapter, a transmitter, etc. For example, the encoder can encode semantically mapped/modulated symbols with any physical layer encoders (such as polar codes, LDPC, turbo codes, etc...).

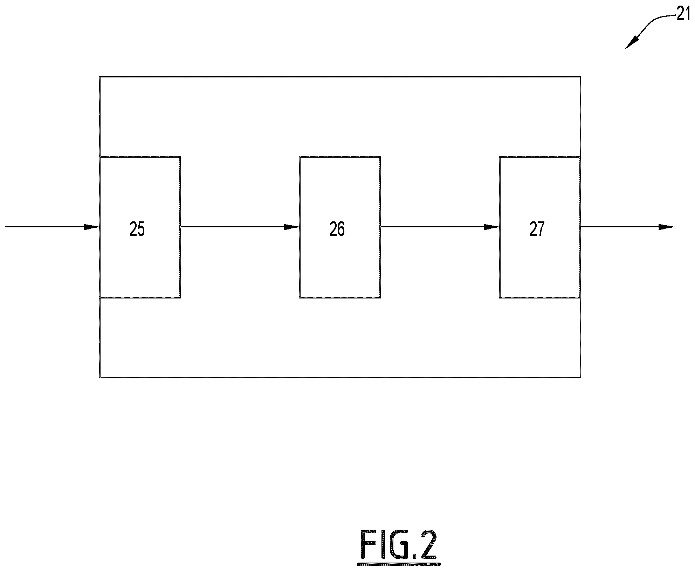

Figure 2 shows in further detail the semantic chain 21 of the sender 12. In reference to this Figure, the semantic chain 21 comprises an application source input 25, a semantic extractor 26 and a semantic modulator 27. The application source input 25 is able to acquire observed data which can for example be communicated to the application source input 25 by one or several sensors (cameras, microphones, thermal sensors, radar, etc.) and/or by an external source. The external source can for example be linked wirelessly to the sender 12. The semantic extractor 26 is able to process the observed data to extract from it semantic concepts. The semantic concepts can for example be selected depending on the targeted semantic compression and resulting communication (wireless channel plus semantic communication) concepts, as it will be explained in further detail below. For this purpose, the semantic extractor 26 can for example use a neural network attention mechanism. The semantic modulator 27 is able to map the semantic concepts extracted by the semantic extractor 26 into semantic symbols. Depending on the target complexity, the semantic modulator 27 can for example determine the average number of semantic symbols required to represent a semantic message. It should be noted that different semantic symbols can be in principle represented with a different number of bits that then are physically transmitted over the wireless channel 16.

The semantic extraction performed by the semantic extractor 26 and the semantic mapping performed by the semantic modulator 27 are carried out using configuration parameters defined for the extractor 26 and the modulator 27. Each couple of such configuration parameters forms a semantic communication mode $SC^{mode_j}$.

The receiver 14 is able to receive the semantic symbols transmitted by the sender 12 over the wireless channel 16 and process them to extract corresponding data. This data can correspond to semantic information and/or allow the receiver 14 to operate an inference or to generate/update a neural network model. The receiver 14 is thus also called "learner". The receiver 14 can present a mobile terminal (such as a smartphone, mobile Edge host, a radio base station, etc.) or an IoT device (such as a sensor, industrial IoT system, etc.). Referring again to Figure 1, similarly to the sender 12, the receiver 14 comprises a semantic chain 31 and a physical layer 32. The physical layer 32 is able to transform radiofrequency signals received from the wireless channel 16 into semantic symbols. Its structure is similar to the structure of the physical layer 22 described in relation with the sender 12. The semantic chain 31 can also be similar to the semantic chain 21 of the sender 12 as previously described. The semantic chain 31 can be configured to operate symmetrically to the semantic chain 21. Particularly, it can for example extract observed data from the semantic symbols transmitted by the sender 12 or process these semantic symbols in any other way, depending notably on the nature of the receiver 14.

The wireless channel 16 comprises any conventional mean (such as different kinds of antennas, modulators, etc.) carrying out wireless transmission using radiofrequency signals presenting a waveform. Additionally, the wireless channel 16 can comprise one or more reconfigurable network nodes configured to carry out at least partially the wireless communication channel. In the following description, it is considered that each reconfigurable network node is a reconfigurable intelligence surface (RIS). However, in a general case, at least one reconfigurable network node can operate using RELAYS or MIMO techniques. The operation of the wireless channel 16 is determined by a plurality of configuration parameters relative to the operation of the different components forming the channel 16. Each plurality of configuration parameters used to operate the different components of the wireless channel 16 forms a wireless communication mode $WC^{mode}_j$ for this channel.

In some embodiments, the semantic communication system 10 may further includes a central unit. This central unit may be configured to supervise the operation of the sender 12, the receiver 14 and/or the wireless channel 16.

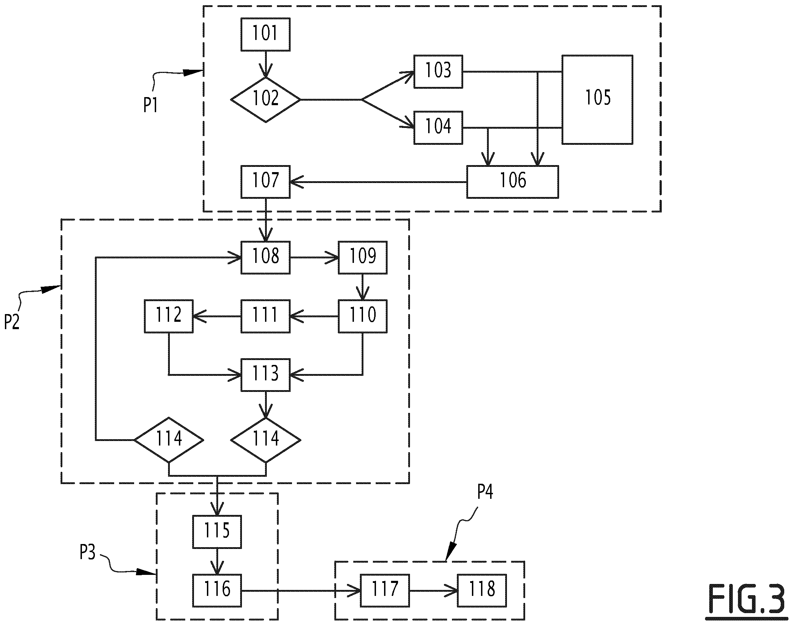

A method for carrying out a semantic communication between the sender 12 and the receiver 14 will now be explained in reference to Figure 3 presenting a diagram of its steps.

It is considered that the sender 12 sends to the receiver 14 data, also called useful data, in a semantic form according for example to the method disclosed in detail in EP 22306910.5. Particularly, as disclosed in this document, this data is transferred via the wireless channel 16 using a waveform. The present disclosure will not explain this semantic communication of the useful data but only how to embed the semantic functions relative to this semantic communication into the same waveform used to transfer the useful data. Therefore, the semantic functions can be transferred simultaneously with the useful data and the semantic communication can be optimized.

The method according to the invention comprises the following phases:

P1: semantic communication setting;
P2: semantic adaption of the waveform;
P3: semantic transmission of the adapted waveform;
P4: semantic receiving.

According to one embodiment, the phases P1 to P3 are carried out by the sender 12 whereas the phase P4 is carried out by the receiver 14. Particularly, phase P1 is carried out by the semantic chain 21 of the sender 12. Phase P2 is carried out by the waveform adapter of the physical layer 22 interacting with the semantic chain 21. Phase P3 is carried out by the transmitter of the physical layer 22 interacting with other components of this layer. According to other embodiments, at least some of these phases are at least partially carried out by the central unit as disclosed above.

During an initial step 110 of phase P1, a new semantic transmission session is started. The following elements are determined during this step:

(1) the actual RF mask of the wireless communication that can be considered static over all communications or changing for instance depending on the carrier frequency of the communication;

(2) the target functions Fi and their number Nf to be embedded simultaneously into the waveform;

(3) the target reliability $F_{i,real}$ per function Fi;

(4) total signal power.

The sender 12 decides to send observed or synthetic data (i.e. useful data) to the receiver 14 in form of semantic message.

During the next step 102 of phase P1, it is checked whether Nf functions can be embedded simultaneously into the same waveform given the constraints from the previous step.

For this purpose, parameters $\alpha_{i,min,Fi}$ corresponding to the minimum number of coefficients in a function to meet target function KPI and parameter $\alpha_{max}$ corresponding to the nominal total number of waveform coefficients in the waveform are defined.

The step therefore checks if:

$$\alpha_{max} \geq \sum_{i=1}^{Nf} \alpha_{i,min,Fi}$$

and

$$\alpha_{i,min,Fi} \leq \alpha_{max}.$$

If Nf functions can be encoded in the same waveform (i.e. the abovementioned expressions are satisfied), the following steps are performed. Otherwise (optional), a lower number of Nf can be accommodated.

In an alternative embodiment, step 102 can suggest the maximum number of functions N'f that can be accommodated into the waveform. In this case, a lower number of functions N''f is provided.

In an alternative embodiment, step 102 does not suggest/request to lower Nf but the algorithm proceeds without fixing a target number Nf but rather looks for the maximum possible Nf to be accommodated.

In the following description, the retained number of functions after this step is denoted as Nf.

During the next step 103 of phase P1 (which can be carried out in some embodiments before step 102), a quality of the semantic communication channel.

The estimated/predicted semantic communication channel quality depends on:

- semantic sender(s) - semantic receiver(s) mismatch of logic adopted to perform semantic extraction (at the sender 12) and semantic interpretation (at the receiver 14);
- semantic communication optimization strategy (ex. trading semantic compression with semantic robustness);
- mismatch of knowledge database at sender 12 and receiver 14 on which semantic extraction and interpretation is based but also on which semantic communication optimization strategy depends on;
- implemented semantic mismatch compensation techniques;
- mismatching training of the transmitter semantic extraction and receiver semantic interpretation trainable functions.

Several embodiments characterizing the semantic communication channel quality are possible.

According to a first embodiment, a binary evaluation is done: good and not good. In this case, a "good" level of quality are attributed when errors due to semantic miss-extraction and miss-interpretation are considered negligible for the end goal of the communication. In the case of a "good" quality, the semantic communication offers at the semantic level, the maximum level of robustness and/or the system assumes that the semantic communication does not introduce errors. Errors, if any, are indeed only due to the wireless channel. Depending on communication scenarios, in the case of "good semantic channel" condition, a set of look up tables (LUT) is precomputed for providing equivalent communication channel quality, by association for example of a physical layer SNR value or more generically by association of a link quality indicator (LQI) to a physical channel. Otherwise, the quality is considered as "not good".

According to a second embodiment, a multi-level discrete evaluation is done: bad semantic channel, average semantic channel and good semantic channel.

This evaluation can be done depending on several factors:

- a semantic communication optimization target metric (for example similarity, equivalence, BLEU, ...);
- a semantic communication teacher-learner shared knowledge database mismatch (for example different training of ML, different domains of application, ...);

- a mismatch of teacher and learner-adopted languages (i.e. different logics) which can be estimated through learning.

In case of a "bad semantic channel", correct semantic communication is not possible even if the wireless communication chain (transmission setting and specific hardware limitations) is good. For instance, even if operating at a high signal-to-noise ratio.

In case of an "average semantic channel", semantic error appears but not all the semantic messages are incorrectly interpreted by the receiver 14. The quality of the wireless communication chain impacts the semantic interpretation success rate at the receiver 14.

In case of a "good semantic channel", correct semantic message interpretation is possible even at low wireless communication chain quality. Thus, a low signal-to-noise ratio (SNR) and/or under-hardware imperfection impacts the effective quality of the received signal.

According to some examples, a multi-level semantic channel classification is done using machine learning-based techniques.

According to a third embodiment, a transformation between source and destination to compensate the semantic channel mismatch is done.

During the next step 104 of phase P1, a quality of the wireless channel is estimated. For this purpose, some possible metrics may be an Instantaneous SNIR (Instantaneous Signal to Noise Ratio), a Capacity, a Channel Gain PER-Indicator (Packet Error Rate), and an exp-ESM (Exponential Effective SNR Mapping).

Then, an optional step 105 of phase P1 can be carried out. During this step, a quality of a virtual semantic-wireless channel link can be estimated based on the previous estimations. Particularly, this step outputs a set of channel constraints parameters determined from channel quality indicators provided during the previous steps.

The virtual semantic-wireless channel link quality is characterized by at least one semantic-wireless metric computed from at least one metric characterizing the wireless link quality and from at least one metric characterizing the semantic link quality.

In a possible embodiment, this allows translating a current measured or estimated RF (or wireless) channel quality into an equivalent semantic-RF (or semantic-wireless) channel quality.

L-levels of virtual semantic wireless-semantic channel link quality may be attributed for the evaluation. For instance:

> **L-1 level** when a joint semantic and physical radio channel is labelled as "good". In that case, no semantic and wireless channel adaptation is needed. Semantic communication parameters are not changed; semantic extraction/mapping and inverse function at the receiver are unchanged from previous(s) communication attempts. Adaptive modulation and coding (AMC) techniques at wireless channel level is operated following rules from previous(s) communication attempts. As an example, this means that wireless channel is good for semantic communications. This means that the SNR exceeds a threshold ($W_{th}$) for which the semantic communication is insensitive to encoding/decoding wireless errors (due to noise and interference).

**L-2 level** when a joint semantic and physical radio channel is labelled as not "good enough": This is the case when the actual wireless channel and the adaptive mechanism configuration have to be improved and/or the semantic strategy is not robust enough given the actual semantic channel and wireless channel. Compared to the L-1 level, the SNR here is below the threshold $W_{th}$, and for the actual $SC^{mode_i}$. A semantic and wireless channel adaptation is triggered.

**L-3 level** when joint virtual semantic and physical radio channel is labelled as "too good". The actual wireless channel and the adaptive mechanism configuration exceed the needs for successful semantic communication. The actual SNR value is higher than $W_{th}$. In this case, instead of increasing the quality of the wireless and/or the semantic transmission settings, the process allows reducing it. This can be implemented with different strategies.

During the next step 106 of phase P1, semantic messages from data to be transmitted are determined. The inputs of this step are: data, semantic and wireless channel quality estimations. The outputs of this step are: semantic messages or semantic concepts (and optionally their relations) or embeddings.

This step comprises a first sub-step of identifying a set of semantic concepts to be communicated. This sub-step can also extract relations between concepts.

The step 106 further comprises a sub-step of selecting from the set sematic concepts depending on a targeted semantic compression to form semantic communications operation points $Sem_{OP}^{Txi,RXj}$ between the sender 12 and the receiver 14. The semantic communications operation points $Sem_{OP}^{Txi,RXj}$ comprise semantic extraction rules and a number of semantic symbols per semantic message.

The targeted semantic compression is defined based on the estimated qualities of the semantic communication channel and the wireless channel and/or eventually on the virtual semantic-wireless channel link quality.

In more detail, the step 106 defines the expected semantic compression versus the nominal semantic robustness (assuming ideal, transparent semantic communication channel). Depending on the targeted semantic compression and the resulting communication (wireless channel plus semantic communication), concepts are selected by a semantic extractor at the sender side (for instance via a neural network attention mechanism). The extraction may further depend on the target complexity that can for instance be measured as the average number of semantic symbols required to represent the semantic message which is composed of semantic concepts and their relations. Different semantic symbols can be in principle represented with a different number of bits that they are physically ready to be transmitted over the wireless channel.

During the next step 107, which is the final step of phase P1, semantic concepts and relations between semantic concepts to be transmitted are extracted.

Therefore, the outputs of this step can be a sequence of concepts $<c_i>$ or a sequence of concepts and their related relations $<r_i>$ or a sequence of embedding representing triples of two concepts and their relation $<T_i>$.

To carry out this step, any semantic extraction method can be applied.

The next phase P2 is carried out for each function within a loop with an index i varying from 1 to Nf.

During an optional step 108 of this phase P2, relevant hardware constraints are determined. This step can comprise two sub-steps.

During a first sub-step, the method determines the relevant hardware constraints for the function $F_l$ and for the wireless waveform shaping. It takes inputs on the RF signal mask and on the hardware constraints at the sender 12 and receiver 14 for the conversion from semantic symbols to the baseband modulated physical signal waveform and the vice versa function at the receiver 14. Such hardware constraints and hardware circuit implementation can be:

- the carrier frequency *f0* and/or the consequent *fmax* (maximal operation radio frequency), which determines the maximum operation frequency and the maximum refreshment (update) and processing frequency of coefficients, and/or the consequent BW $f_{BW}$ (largest bandwidth of operation); which determines the maximum refreshment frequency of coefficients.

- maximum number of the orthogonal base coefficients to transmit on the waveform of $\alpha_{max,HW}$ (for instance in the Walsh base Transform as it will explained below) that can be used.

- $Q_{res-max}$: how many bits per coefficient the hardware quantization can support, which determines the spectrum occupancy described in SNR, bandwidth, and thus, mask respect. For instance, a higher resolution enables a more accurate combination and increases the SNR, giving spectral flexibility and more possibilities to respect the operating mask.

- the minimum refreshing frequency of coefficients, *fmin* is determined by the mask constraints, $\alpha_{max,HW}$ and $Q_{res-max}$.

- the signal mask imposed by the spectrum operations provides requirements on coefficient parameters with minimum requirements such as the number of coefficients to be used and their address, the maximum and minimum frequencies *fmax* and *fmin,* to respect the carrier frequency $f_0$ and the available bandwidth $f_{BW}$.

- the maximum resolution for the coefficients is limited by the integrated circuit performing the conversion. It is determined by the technology performances, the architecture complexity (exponential for every extra bit), and thus the linearity and the power consumption.

This sub-step can present at least two types of output:

- void output, meaning that no hardware constraints are needed to be considered;
- a set of hardware constraints to be considered for the waveform shaping algorithm.

During a second sub-step, the method estimates/computes the impact of the hardware constraints on the semantic waveform degradation by evaluating its impact on the resulting semantic interpretation performance degradation at the receiver.

During the next step 109 of phase P2, a set of semantic waveform operation points is selected to adapt the waveform based on a waveform adaption strategy.

This step can also comprise several sub-steps.

During a first sub-step, a set of intentional waveform degradations is evaluated to reduce the number of clusters of coefficients per function Fi end the number of coefficients per cluster (as it will be explained below) based on the hardware constraints determined during the previous step.

The possible intentional degradations are driven by the hardware constraints and may include:

- reduction of number of coefficients $\alpha_{max,HW}$ to reduce hardware consumption which is directly proportional to the number of coefficient to be transmitted and received and signal processing complexity.

- sub-optimal selection of number of clusters for the selected function (ex. communication, sensing, localization, etc.).

- sub-optimal allocation between coefficients and clusters to achieve the best coefficient grouping in the same cluster and related coefficient interdependency.

- hardware limitation of coefficient resolution. This translates in a limited quantization capability of hardware per coefficient.

- constraint of total power for transmitted coefficients.

Given (1) a virtual joint semantic-wireless channel, (2) the number of functions to be encoded simultaneously into the same waveform, (3) the hardware constraints, at this stage a limited set of candidate waveform degradation is computed and its performance degradation evaluated. Such degradation is compensated by the semantic communication robustness, thus ensuring that the target function reliability *Fi* is respected.

According to one example, the number of candidate waveform degradation is obtained by exhaustive search. Another example comprises fixing a threshold of degradation and stopping the exhaustive search after computing X degradations that exceed the threshold. The threshold can arbitrary be fixed or learned via machine learning.

During a second sub-step, the waveform adaption strategy is chosen based on at least one of the elements chosen in the group comprising:

- no adaption of the waveform shaping;

- adaptation only considering the estimated quality of the semantic communication channel (for example the number of concepts per messages to be extracted, the number of semantic symbols per messages to be transmitted, etc.);

- adaptation only considering the estimated quality of the wireless channel (for example the modulation and coding scheme, the number of antennas at the transmitter and receiver, etc.);

- adaptation considering an estimated quality of a virtual semantic-wireless channel link;

- adaption according to hardware constraints;

- adaptation to improve wireless channel or semantic communication channel or virtual semantic-communication channel robustness, notably in case when the semantic and or the wireless channel quality are not good enough;

- adaptation to reduce wireless channel or semantic communication channel or virtual semantic-communication channel robustness, notably in case when the semantic and or the wireless channel quality are "too good" and resource parsimony can be applied.

In other words, this step defines the set of possible operation points given the inputs constraint on the wireless and semantic channel or alternatively on the joint virtual semantic and wireless channel. It depends also on the RF waveform shaping constraints and possible combination of waveform settings imposed/offered by the communication system.

As a non-limiting example, a set of constraints parameters may comprise for the semantic channel, constraints on a number of semantic symbols, information on semantic robustness versus compression trade-off, semantic encoding rules, and for the wireless channel, constraints related to the amplitude of coefficients, to a number of coefficients, to the type of coefficients, to the refresh period of coefficients.

It should be noted that several parameters of an RF signal can be adapted but not all combinations are possible since the overall signal shape has to respect constraints to guarantee the signal mask on the spectrum spread (in general imposed by the system or by the specific standard). For example, parameters of such semantic and RF signal can be adapted are:

- number of semantic symbols included into the waveform;
- number of waveform coefficients combined in the same waveform;
- amplitude of waveform coefficients;
- specific placement of waveform coefficients in the waveform;
- number of waveform coefficients per each semantic symbol.

During the next step 110 of phase P2, waveform degradation impact on semantic interpretation at the receiver for the set of semantic waveform operation points is estimated.

The sender 12 can evaluate the message interpretation at the receiver 14 for the set of waveform operation points $SWF_{op}$ using at least one of the following elements:

- linking the link quality metric (LQM) over the channel (wireless only, semantic and wireless or joint semantic and wireless) with the reliability measure of the function *Fi.*

- the receiver has an emulator (twin) of the receiver semantic interpretation and estimates the effect of the waveform changes and setting on the final function *Fi* performance.

If during step 109, no adaption of the waveform is performed, the method goes directly to step 113 of phase P2. Otherwise, steps 111 and 112 are performed before.

During step 111 of phase P2, the semantic waveform operation points $SWF_{op}$ are ranked to obtain a ranked set of semantic waveform operation points $SWF_{op\_ranked}$.

The ranking of the semantic waveform operation points is based on at least one of the elements chosen in the group comprising:

- minimal coefficient use/occupation of the corresponding function *Fi*;
- minimal associated transmission function at the sender 12;
- maximal semantic communication compression;
- maximal function reliability against wireless channel noise and interference;
- maximal function reliability against semantic communication channel noise;
- maximal function reliability against truncated computation at semantic interpretation.

During step 112 of phase P2, semantic waveform operation points $SWF_{op-j}$ are selected from the ranked set $SWF_{op\_ranked}$ based on a predetermined threshold. The threshold can be chosen by either the central unit or the sender 12, or suggested via a feedback channel by the sender 12.

During step 113 of phase P2, the waveform coefficients of an associated function presenting the waveform are divided into clusters and semantic symbols are associated to each cluster representing a semantic concept. A cluster can also embed multiple semantic symbols. It can be also that a semantic symbol spams over multiple clusters.

Several embodiments of this step 113 are possible based notably on the type of the function representing the waveform.

For example, considering a waveform f(x) represented with a sequence of N coefficients wi and gi(t) functions are mathematical model or function that closely matches the desired waveform (sine, cosine, square, triangular, sawtooth, Gaussian, etc.). This function can present the following form:

$$f(x) = \sum_{i=1}^{N} w_i \cdot g_i(t)$$

The functions gi(t) form an orthogonal basis.

To form cluster, it can for example be taken into account that some of waveform coefficients are 0. So, clusters can be formed to include the non-zero coefficients depending on the (adaptive) waveform shaping strategy used for sending the RF signal.

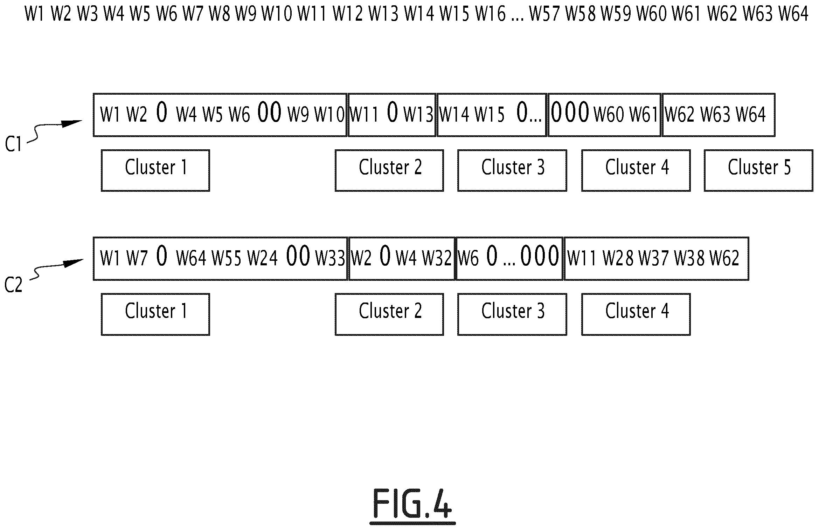

Figure 4 shows an example of a contiguous clustering C1 and a non-contiguous clustering C2 formed from the waveform coefficients w1 to w64.

According to another example, the waveform is presenting using the sequential Walsh transform coefficients $W_i$. To write a waveform using Walsh Transforms, Walsh functions which are square waves functions that oscillate between -1 and 1 are used. The Walsh functions can be defined recursively as follows:

$$W_0(t) = 1$$

$$W_1(t) = \text{sign}\,(\sin(\pi t))$$

$$W_{n+1}(t) = \text{sign}\,(\sin(2^n\,\pi t)) * W_n(2t)$$

where sign (x) returns:

- -1 for x<0,
- 0 for x=0
- -1 for x>0

The Walsh Transform of a waveform f(t) is given by:

$$F(k) = \int_0^1 f(t) \cdot W_k\, dt$$

where F(k) represents the amplitude of the waveform in the Walsh domain at the k-th Walsh function.

The general procedure to write a waveform using Walsh Transforms can consist in the following sub-steps:

- define the waveform you want to represent, f(t), with a mathematical expression.
- compute the Walsh Transform coefficients, F(k), by integrating the product of f(t) and each Walsh function Wk(t) over the interval [0, 1].
- express the waveform as a linear combination of the Walsh functions using the computed coefficients.

The waveform coefficients can be clustered depending on the correlation between the corresponding semantic concepts. When concepts are completely distinct, the corresponding coefficients can be clustered in different clusters. When the concepts are close, the corresponding coefficients may be in close clusters or in the same cluster.

During the next step 114 of phase P2, a loop halt is checked. Particularly, the loop is stopped when all functions have been processed (i.e. when i=Nf) or when no residual waveform coefficient remains. A residual waveform coefficient refers to any waveform coefficient that has not been used after allocating all the functions.

If the loop is stopped, the next phase P3 is carried out. Otherwise, the index i is incremented and step 108 or 109 is carried out.

During an initial step 115 of phase P3, a multifunction waveform embedding all of the functions processed in the previous phase P2 is formed.

Particularly, for each function Fi, messages are extracted as semantic messages and then translated into an RF signal. The information is extracted in semantic form. Particularly, semantic messages can be formally composed by:

- embedding representing a triple of two extracted concepts and their relation;
- semantic symbols $c_i$ (as for instance letters of an alphabet to represent words) into one or several sequences of semantic coefficients $<c_i>$.

Each semantic symbol is then translated into a sequence of coefficients (for example a sequence of Walsh coefficients (Wi)). Each function Fi has the clusters of coefficients and the coefficients in the clusters defined in step 113. It should be notes that at this step the use of the coefficients is not free in amplitude, in number, in placement, in synchronization and it has to respond to constraints to guarantee a respect of spectrum use (context, environment, standard).

When the coefficients are selected, the waveform design is computed taking into account:

- the coefficients order (thus a number of sequences);
- a quantization of the coefficients (for example 8 bits, meaning 28 quanta for amplitude quantification);
- a combination and placement of coefficients over N coefficients;
- timing of coefficients refreshment.

During the next step 116, the multifunction waveform is wirelessly transmitted via the wireless channel 16.

During an initial step 117 of phase P4, an RF signal composed of the waveform coefficients is received by the receiver 14. Each coefficient is converted into amplitude (quantization), number (defined by the context), placement ("i") and in accordance with the spectral rules. The coefficients are then translated into semantic symbols.

During the next optional step 118 of phase P4, the receiver checks 14 the correct reception and feedbacks to the central unit if communication has occurred correctly overall (or alternatively) selectively specifying which function has not reached the target function reliability.

It can be conceived that the invention presents a certain number of advantages.

Particularly, the invention proposes to embed simultaneously several semnatic functions in the same waveform. An example is the joint communication and sensing.

For this purpose, at least one wireless waveform shape for the semantic message is determined, taking into account constraints on wireless and semantic channels as well as on hardware. The waveform is formed with an orthogonal basis that could decompose a waveform under temporal, sequential or frequencial forms, using coefficients derived with a proper temporal, sequential or frequential transform and any associated techniques.

The communication is performed via a semantic communication chain, where transmitted data (for all the functions) is encoded and decoded via a semantic chain. For instance, in case of an integrated sensing and communication, the sensing functionality share information on the sensing via semantic interpretation and extraction, thus being prone to the semantic channel quality.

In some embodiments, only part of the function are transmitted via a semantic chain and part not. This might depend also on the semantic capability of the sender and receiver.

**Claims**

1. A method for carrying out a semantic communication within a semantic communication system (10) defining a semantic communication channel, the semantic communication system (10) comprising a sender (12) and a receiver (14) connected through a wireless channel (16), the method comprising the following phases:

    - semantic communication setting comprising determining multiple semantic functions to be embedded into a waveform;
    - semantic adaption of the waveform to embed the multiple semantic functions;
    - semantic transmission of the adapted waveform in a form of an electromagnetic signal.

2. The method according to claim 1, wherein each semantic function comprises a functionality chosen in the list comprising:

    - communication;
    - sensing;
    - localization;
    - semantic symbols transmission;
    - machine learning training;
    - synchronization;
    - context estimation.

3. The method according to claim 1 or 2, wherein the phase of semantic communication setting comprises the following steps:

    - determining (101) of a target number Nf of the multiple semantic functions to be embedded into the waveform;
    - checking (102) whether the Nf functions can be embedded simultaneously into the same waveform;
    - estimating (103) a quality of the semantic communication channel;
    - estimating (104) a quality of the wireless channel;
    - determining (106) semantic messages from data to be transmitted comprising the following sub-steps:

    - identifying a set of semantic concepts to be communicated;
    - selecting from the set sematic concepts depending on a targeted semantic compression to form semantic communications operation points between the sender (12) and the receiver (14), the targeted semantic compression being defined based on the estimated qualities of the semantic communication channel and the wireless channel;

    - extracting (107) semantic concepts and relations between semantic concepts to be transmitted.

4. The method according to claim 3, wherein if during the checking step (102) the Nf functions cannot be embedded simultaneously into the same waveform, said step further comprising determining a maximal number of functions that can be embedded into the waveform;
the other steps of the method being implemented for this maximal number of functions.

5. The method according to claim 3 or 4, wherein the phase of semantic communication settings further comprises a step (105) of estimating a quality of a virtual semantic-wireless channel link, the targeted semantic compression being defined based on said virtual semantic-wireless channel link quality.

6. The method according to any one of claims 3 to 5, wherein the phase of semantic adaption of the waveform comprises the following steps carried out for each semantic function:

    - selecting (109) of a set of semantic waveform operation points to adapt the waveform based on a waveform adaption strategy;
    - estimation (110) of waveform degradation impact on semantic interpretation at the receiver (14) for the set of semantic waveform operation points;
    - ranking (111) of the semantic waveform operation points;
    - selection (112) of ranked semantic waveform operation points based on a predetermined threshold;
    - for the selected waveform operation points, determining (113) clusters of waveform coefficients of an associated function presenting the waveform and associating semantic symbols to each cluster representing a semantic concept;
    - checking (114) for a loop halt.

7. The method according to claim 6, wherein the waveform adaption strategy comprises at least one of the elements chosen in the group comprising:

- adaptation only considering the estimated quality of the semantic communication channel;
- adaptation only considering the estimated quality of the wireless channel;
- adaptation considering an estimated quality of a virtual semantic-wireless channel link;
- adaptation to improve wireless channel or semantic communication channel or virtual semantic-communication channel robustness;
- adaptation to reduce wireless channel or semantic communication channel or virtual semantic-communication channel robustness.

8. The method according to claim 6 or 7, wherein the phase of semantic adaption of the waveform further comprises a step (108) of determining relevant hardware constraints, the waveform adaption strategy further comprising adaption based on the relevant hardware constraints.

9. The method according to any one of claims 6 to 8, wherein the adaptation of the waveform includes adaptation of one the elements chosen in the group comprising:

- number of semantic symbols included into the waveform;
- number of waveform coefficients combined in the same waveform;
- amplitude of waveform coefficients;
- specific placement of waveform coefficients in the waveform;
- number of waveform coefficients per each semantic symbol.

10. The method according to any one of claims 6 to 9, wherein the ranking of the semantic waveform operation points is based on at least one of the elements chosen in the group comprising:

- minimal coefficient use/occupation of the corresponding function Fi;
- minimal associated transmission function at the sender (12);
- maximal semantic communication compression;
- maximal function reliability against wireless channel noise and interference;
- maximal function reliability against semantic communication channel noise;
- maximal function reliability against truncated computation at semantic interpretation.

11. The method according to any one of claims 6 to 10, wherein during the step (114) of checking for a loop halt, the loop is stopped when all functions have been processed or when no residual waveform coefficient remains.

12. The method according to any one of the preceding claims, wherein the phase of semantic transmission comprises the following steps:

- generation (115) of a multifunction waveform;
- wireless transmission (116) of the multifunction waveform.

13. The method according to any one of the preceding claims, further comprising a phase of semantic receiving comprising the following steps:

- reception (117) of an electromagnetic signal comprising reception of each waveform coefficient, its conversion into amplitude, number and placement in accordance with spectral rules, the coefficient being then translated into semantic symbols;
- checking (118) of the correct reception and creating a feedback to the sender (12).

14. A semantic communication system (10) comprising:

- a sender (12) able to generate and send semantic symbols;
- a receiver (14) able to receive the semantic symbols and process them to extract corresponding data;
- a wireless channel (16) configured to transmit the semantic symbols in form of radio signals, from the sender (12) to the receiver (14);

the sender (12), the receiver (14) and the wireless channel (16) being adapted to carry out the method according to any one of claims 1 to 13.

FIG.1

FIG.2

FIG.3

W1 W2 W3 W4 W5 W6 W7 W8 W9 W10 W11 W12 W13 W14 W15 W16 ... W57 W58 W59 W60 W61 W62 W63 W64

C1

| W1 W2 0 W4 W5 W6 00 W9 W10 | W11 0 W13 | W14 W15 0... | 000 W60 W61 | W62 W63 W64 |

| Cluster 1 | | Cluster 2 | Cluster 3 | Cluster 4 | Cluster 5 |

C2

| W1 W7 0 W64 W55 W24 00 W33 | W2 0 W4 W32 | W6 0 ... 000 | W11 W28 W37 W38 W62 |

| Cluster 1 | | Cluster 2 | Cluster 3 | Cluster 4 |

FIG.4

EP 4 657 780 A1

Europäisches
Patentamt

European
Patent Office

Office européen
des brevets

# EUROPEAN SEARCH REPORT

**Application Number**

EP 24 30 5830

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SHUAISHUAI GUO ET AL: "Semantic Importance-Aware Communications with Semantic Correction Using Large Language Models", ARXIV.ORG, CORNELL UNIVERSITY LIBRARY, 201 OLIN LIBRARY CORNELL UNIVERSITY ITHACA, NY 14853, 25 May 2024 (2024-05-25), XP091767660, * the whole document * | 1-14 | INV. H04L1/00 H04L5/00 H04L5/02 H04L27/02  ADD. H03M7/30 H03M13/31 H03M13/35 |
| A | WO 2023/113302 A1 (LG ELECTRONICS INC [KR]) 22 June 2023 (2023-06-22) * paragraph [0187] - paragraph [0319] * * figures 13-21 * | 1-14 | |
| A | ZHANG WENYU ET AL: "DeepMA: End-to-End Deep Multiple Access for Wireless Image Transmission in Semantic Communication", IEEE TRANSACTIONS ON COGNITIVE COMMUNICATIONS AND NETWORKING, IEEE, USA, vol. 10, no. 2, 19 October 2023 (2023-10-19), pages 387-402, XP011965896, DOI: 10.1109/TCCN.2023.3326302 [retrieved on 2023-10-20] * the whole document * | 1-14 | TECHNICAL FIELDS SEARCHED (IPC)  H04L H03M |
| E | EP 4 447 348 A1 (COMMISSARIAT ENERGIE ATOMIQUE [FR]; UNIV BORDEAUX [FR] ET AL.) 16 October 2024 (2024-10-16) * the whole document * | 1-14 | |

The present search report has been drawn up for all claims

| Place of search | Date of completion of the search | Examiner |
|---|---|---|
| Munich | 30 October 2024 | Gardella, Simone |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 5830

This annex lists the patent family members relating to the patent documents cited in the above-mentioned European search report.
The members are as contained in the European Patent Office EDP file on
The European Patent Office is in no way liable for these particulars which are merely given for the purpose of information.

30-10-2024

| Patent document cited in search report | Publication date | Patent family member(s) | Publication date |
|---|---|---|---|
| WO 2023113302 A1 | 22-06-2023 | NONE | |
| EP 4447348 A1 | 16-10-2024 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 22306910

**Non-patent literature cited in the description**

- Recent Contributions to the Mathematical Theory of Communication. **WEAVER, W.** The Mathematical Theory of Communication. 1949